# EUROPEAN PATENT APPLICATION

(11) **EP 1 288 331 A1**
(43) Date of publication of application: **05.03.2003**
(21) Application number: 02019439.5
(22) Date of filing: 30.08.2002
(51) Int. Cl.: C23C 14/24

(54) **Vapor deposition crucible opened on both sides**

(30) Priority: 03.09.2001 JP 2001265628
(71) Applicant: HOYA CORPORATION, Shinjuku-ku, Tokyo 161-8525 (JP)
(72) Inventor: Shinde, Ken-ichi, c/o Hoya Corporation, Tokyo 161-8525 (JP); Adachi, Makoto, c/o Hoya Corporation, Tokyo 161-8525 (JP); Imizu, Takeshi, c/o Hoya Corporation, Tokyo 161-8525 (JP); Mitsuishi, Takeshi, c/o Hoya Corporation, Tokyo 161-8525 (JP)
(74) Representative: von Samson-Himmelstjerna, Friedrich R., Dipl.-Phys.

(57) **Abstract**

A vapor deposition crucible includes a crucible main body which is open to upper and lower sides and has a cavity in which a sintered pellet as a vapor deposition material is stored. The cavity of the crucible main body has two cavity portions. A first cavity portion connected to an opening open to the lower side is formed to make the sintered pellet to be stored fit in the first cavity portion. A second cavity portion connected to an opening open to the upper side is formed to form a gap between the second cavity portion and the sintered pellet to be stored. A step like portion is at least partially formed at a connection portion between the first cavity portion and the second cavity portion.

## Description

### Background of the Invention

The present invention relates to a vapor deposition crucible which stores a vapor deposition material formed as a sintered pellet.

A vapor deposition apparatus which melts and vaporizes a vapor deposition material using an electron beam as a heat source and deposits the vapor deposition material on a vapor deposition target such as a substrate or a lens for glasses has, in a water-cooled copper hearth, a vapor deposition crucible having an open upper portion. A vapor deposition material formed as a sintered pellet is charged in this crucible, the sintered pellet is irradiated from the upper side with an electron beam in a vacuum atmosphere to melt and evaporate the sintered pellet, thereby executing vapor deposition on the vapor deposition target.

When vapor deposition on the vapor deposition target is ended, the vapor deposition material cools and hardens. If the molten portion of the sintered pellet has cooled and hardened in contact with the inner surface of the crucible, that portion sticks to the inner surface of the crucible. The bonding strength of the sticking portion of the vapor deposition material to the crucible is high. For this reason, to reuse the crucible, the hardened portion of the sintered pellet must be struck and broken using an appropriate tool to separate the sintered pellet from the crucible. In addition, small pieces remaining on the inner surface of the crucible must also be removed by striking them or scraping them off using an appropriate tool. This work is very difficult. Furthermore, if the sintered pellet is forcibly broken and separated, the crucible may deform or be damaged. Hence, the vapor deposition crucible must have a shape and structure easy to separate the sintered pellet after vapor deposition.

Various kinds of crucibles have been conventionally proposed to solve these problems, though they have both merits and demerits.

For example, in a vapor deposition crucible described in Japanese Utility Model Laid-Open No. 3-18162, the upper and lower portions of the crucible are open to form a sintered pellet storing cavity having a substantially circular section. That is, the inner diameter of the crucible is almost equal to the outer diameter of a sintered pellet.

In a vapor deposition crucible described in Japanese Utility Model Publication No. 6-9011, the upper and lower portions of the crucible are open. In addition, the side wall of the crucible is tilted such that the internal space of the crucible that stores a sintered pellet is tapered downward.

In the above-described vapor deposition crucible described in Japanese Utility Model Laid-Open No. 3-18162, since the upper and lower portions of the crucible are open, a tool can be inserted either from the upper or lower side. In addition, since the hole is straight, when a force is applied from the opening side in parallel to the inner wall, the crucible hardly deforms because no crucible inner wall is present in that direction. Hence, the vapor deposition material can easily be removed. For this removing operation, an appropriate tool such as a metal rod (push rod) having an appropriate diameter is used. In some cases, however, a portion that has cooled and hardened after heating and melting is in contact with the inner wall surface of the crucible in a wide area and therefore has a high bonding strength. The cooled and hardened portion is difficult to break even when a push rod is used. If the portion is forcibly broken and separated, the crucible is deformed, resulting in a short service life.

In the above-described vapor deposition crucible described in Japanese Utility Model Publication No. 6-9011, the side wall tilts to taper the internal space downward. Hence, when a columnar sintered pellet is inserted, a gap is formed between the side surface of the sintered pellet and the inner wall surface of the crucible. When the molten vapor deposition material flows downward along the side surface of the pellet, the vapor deposition material stays in the gap between the pellet side surface and the inner wall surface of the crucible. For this reason, the contact area becomes large to increase the bonding strength, like Japanese Utility Model Laid-Open No. 3-18162, and the vapor deposition material is hard to break.

In addition, in the vapor deposition crucible described in Japanese Utility Model Publication No. 6-9011, since only the lower edge of a columnar sintered pellet is supported in contact with the inner wall surface, the sintered pellet itself readily tilts. In some cases, the vapor deposition material heated and molten flows downward between the inner wall surface of the crucible and the lower edge of the sintered pellet, resulting in large loss. In this case, the vapor deposition material may be insufficient. Alternatively, since the melting surface of the sintered pellet excessively falls down, and the position where an electron beam strikes also deviates from the center, no uniform deposited film can be formed. The vapor deposition material that has flown into the water-cooled copper hearth must also be removed. When a push rod is inserted from the upper opening portion of the crucible having the tilted inner wall surface to remove the sintered pellet from the crucible, the sintered pellet is pressed against the inner wall. If the force is forcibly applied, the crucible deforms. Hence, the rod must be inserted from the lower opening portion.

### Summary of the Invention

It is therefore a principal object of the present invention to provide a vapor deposition crucible capable of easily breaking a hardened portion of a sintered pellet after vapor deposition.

It is another object of the present invention to provide a vapor deposition crucible capable of easily removing a sintered pellet from the crucible.

It is still another object of the present invention to provide an improved vapor deposition crucible that does not impede sliding operation of the crucible.

In order to achieve the above objects, according to the present invention, there is provided a vapor deposition crucible comprising a crucible main body which is open to upper and lower sides and has a cavity in which a sintered pellet as a vapor deposition material is stored, wherein the cavity of the crucible main body has two cavity portions, a first cavity portion connected to an opening open to the lower side is formed to make the sintered pellet to be stored fit in the first cavity portion, a second cavity portion connected to an opening open to the upper side is formed to form a gap between the second cavity portion and the sintered pellet to be stored, and a step like portion is at least partially formed at a connection portion between the first cavity portion and the second cavity portion.

### Brief Description of the Drawings

Fig. 1 is a perspective view showing the outer appearance of a vapor deposition crucible according to the first embodiment of the present invention before a sintered pellet is charged therein;
Fig. 2 is a sectional view showing a state wherein the sintered pellet of the first embodiment before vapor deposition is stored in the crucible;
Fig. 2A is a partially enlarged sectional view showing a modification of a step like portion shown in Fig. 2;
Fig. 3 is a sectional view showing the state of the sintered pellet in the crucible of the first embodiment after vapor deposition;
Figs. 4A to 4C are views for explaining the states of portions where the vapor deposition material is molten and sticks near the step like portion in the first embodiment;
Fig. 5 is a partially cutaway perspective view showing the main part of a vapor deposition crucible according to the second embodiment of the present invention;
Fig. 6 is a perspective view showing a vapor deposition crucible according to the third embodiment of the present invention;
Fig. 7 is a sectional view of the third embodiment;
Fig. 8 is a sectional view showing a vapor deposition crucible according to the fourth embodiment of the present invention;
Fig. 9 is a sectional view showing a vapor deposition crucible according to the fifth embodiment of the present invention;
Fig. 10 is a perspective view showing the outer appearance of a vapor deposition crucible according to the sixth embodiment of the present invention; and
Fig. 11 is a plan view showing an example in which the crucible shown in Fig. 2 is stored in the recessed storage portion of a water-cooled copper hearth.

### Description of the Preferred Embodiments

The present invention will be described below in detail on the basis of embodiments.

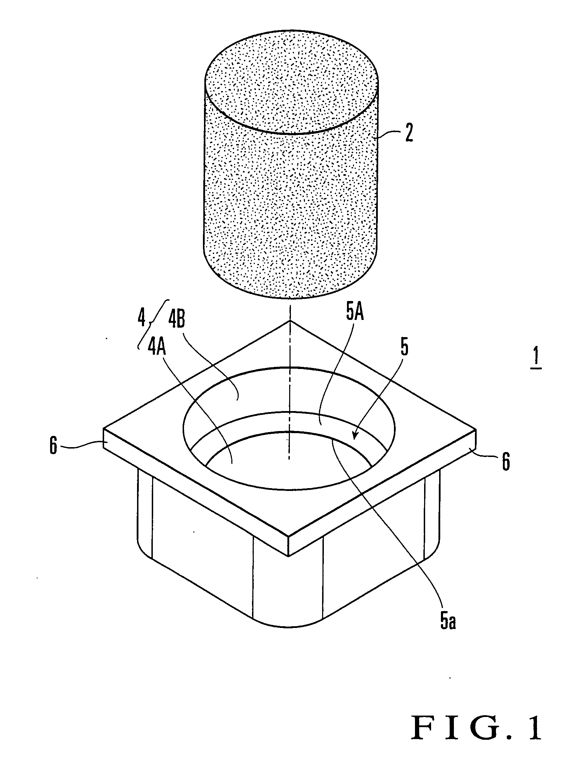

Figs. 1 to 3 show a vapor deposition crucible according to the first embodiment of the present invention. Referring to Figs. 1 to 3, reference numeral 1 denotes a vapor deposition crucible (to be simply referred to as a crucible hereinafter); 2, a sintered pellet charged into the crucible 1; and 3, a water-cooled copper hearth.

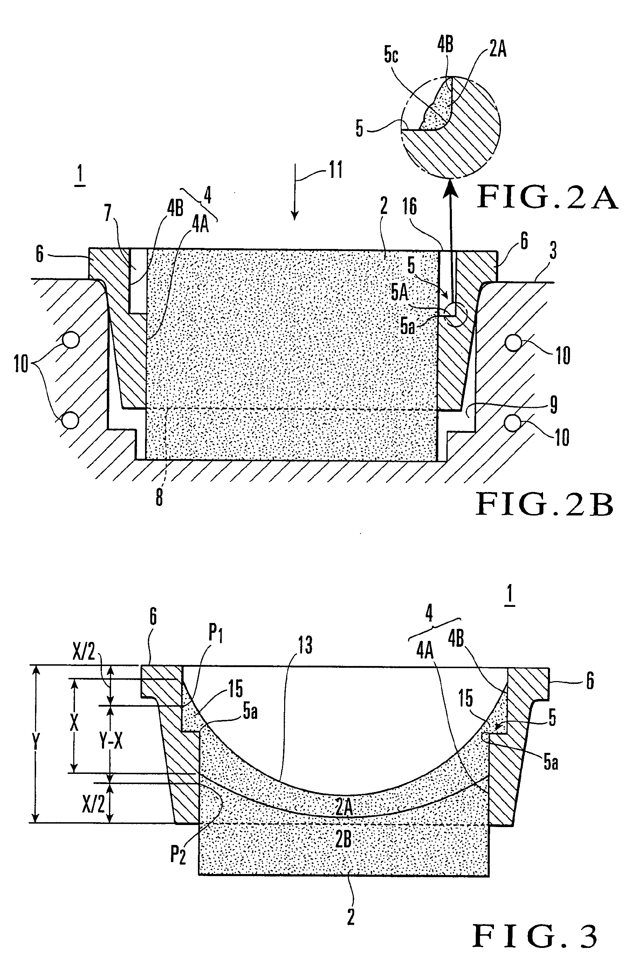

The crucible 1 comprises a crucible main body having a cavity 4 in which the sintered pellet 2 is charged. The cavity 4 is open to the upper and lower sides of the crucible 1. A lower opening 8 of the crucible 1 has the same size as a first cavity portion 4A extending from the opening 8 and opens the entire bottom portion. An upper opening 16 has the same size as that of a second cavity portion 4B extending from the opening 16 and opens the entire upper portion. Hence, the openings 8 and 16 formed at the upper and lower portions of the crucible 1 have difference diameters. The first cavity portion 4A extending from the opening 8 has such a hole diameter that the lower portion of the sintered pellet 2 can be fitted therein. The second cavity portion 4B extending from the opening 16 is located above the first cavity portion 4A and has a hole diameter larger than that of the first cavity portion 4A. The first and second cavity portions 4A and 4B are substantially coaxially formed. A step like portion 5 is circumferentially formed at the connection portion between the first and second cavity portions 4A and 4B. This step like portion 5 has a step-like sectional shape, as shown in Figs. 2 and 3. For the step like portion 5, an edge or ridge 5a is always formed at the connection portion between a step surface 5A and the inner wall surface of the first cavity portion 4A. The step surface 5A need not always be perpendicular to the axial line of the crucible 1. The step surface 5A may slightly tilt as long as it has the edge or ridge 5a.

The crucible 1 has a rectangular shape when viewed from the upper side. Two opposing sides of the crucible 1 integrally have flange portions 6 supported by the water-cooled copper hearth 3. The flange portion 6 has a function of easily sliding a recessed storage portion 9 and also preventing any hindrance of the slidable movement of the crucible 1 by preventing a vapor deposition material from entering the recessed storage portion 9 from the gap formed between the crucible 1 and the recessed storage portion.

The water-cooled copper hearth 3 is formed from a plate made of copper and having an appropriate thickness. The water-cooled copper hearth 3 has the recessed storage portion 9 for storing the crucible 1 on the upper surface and cooling water channels 10 in the plate. The water-cooled copper hearth 3 is installed in a vacuum apparatus. The central portion of the upper surface of the sintered pellet 2 is irradiated with an electron beam 11 to heat and melt the upper surface portion of the sintered pellet 2, thereby depositing the material on a vapor deposition target such as a lens for glasses. As the structure of the water-cooled copper hearth 3, for example, those described in Japanese Utility Model Laid-Open No. 5-72964 and Japanese Utility Model Publication No. 7-45560 are known.

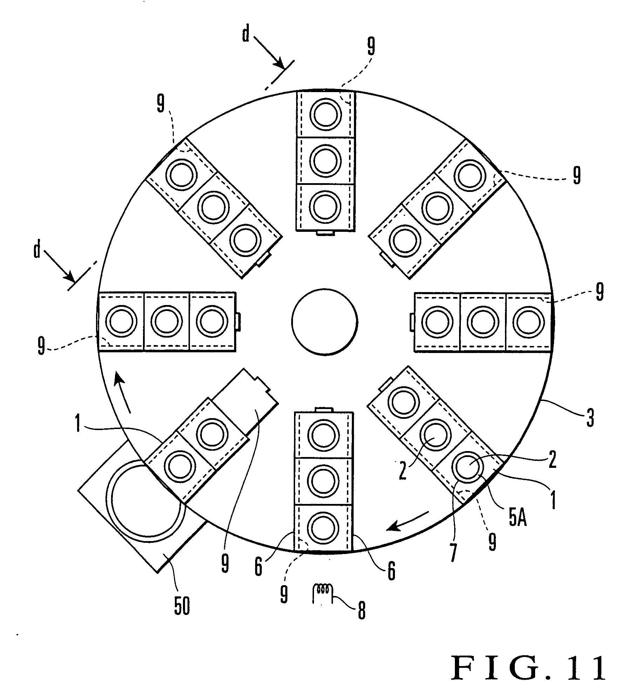

Fig. 11 shows a state wherein the crucible 1 of the first embodiment of the present invention is applied to a vapor deposition apparatus described in Japanese Utility Model Laid-Open No. 5-72964. In this case, Fig. 2 described above shows a section taken along a line P - P in Fig. 11. Fig. 11 will be described. The water-cooled copper hearth 3 has a circular plate shape. Eight recessed storage portions 9 are radially arranged at an equal angular interval. Three crucibles 1 are stored in each recessed storage portion 9 such that they are radially and slidably aligned. When a vapor deposition process for the crucible 1 near the edge is ended, the crucible 1 that has undergone the vapor deposition process is slidably dropped from the edge of the water-cooled copper hearth 3 to a crucible storage 50. Simultaneously, the next crucible 1 is moved to the vapor deposition position, and the next vapor deposition process is executed. The recessed storage portion 9 has a width slightly larger than that of the crucible 1. Hence, the crucible 1 that is being suspended at the edge of the recessed storage portion 9 by the flange portions 6 can slide along the edge of the water-cooled copper hearth 3. In this example, the crucibles 1 each having the flange portions 6 and a rectangular shape when viewed from the upper side are aligned in each recessed storage portion 9, as shown in Fig. 11. For this reason, no gap is formed between the crucibles 1 adjacent in the sliding direction, and the sliding operation of the crucible 1 is not impeded.

As the material of the crucible 1, a material having a high thermal conductivity, such as copper, aluminum, graphite, or tungsten, is normally used. The crucible 1 has a block shape with a size of 31 (length) × 31 (width) × 12 (height) mm. The first cavity portion 4A has a circular cross section and a hole diameter of 22.6 mm. The second cavity portion 4B also has a circular cross section and a hole diameter of 25 mm. The distance from the upper surface of the crucible to the step like portion 5 is 5 mm.

When the first and second cavity portions 4A and 4B have circular cross sections, the inner wall surface of each cavity portion forms a continuous curved surface having a specific curvature. Since no bent surface or corner is formed, a slender rod-shaped tool can reliably be brought into contact with any portion of the inner wall surface of each cavity portion. For this reason, the vapor deposition material can easily be removed.

The sintered pellet 2 to be used in this embodiment is obtained by molding powder of a vapor deposition material by a press, heating and sintering the material at 1,000°C to 1,400°C under the atmospheric pressure by an electric furnace. The sintered pellet 2 has a cylindrical shape whose diameter is slightly smaller than the first cavity portion 4A. To deposit an anti-reflection film on a lens for glasses, a vapor deposition material such as niobium oxide, tantalum oxide, titanium oxide, zirconium oxide, or yttrium oxide, is used. For example, niobium oxide (Nb₂O₅) powder and zirconium oxide (ZrO₂) powder are mixed at a weight ratio of 95 : 5, pressed at 300 kg/cm, and heated to 1,300°C for 24 hrs, thereby manufacturing a cylindrical sintered pellet having a diameter of 21.8 to 22.5 mm and a height of 15.5 to 16.0 mm.

When this sintered pellet 2 is being charged in the crucible 1, the upper end portion of the sintered pellet 2 is located above the step like portion 5 to form an annular gap between the sintered pellet and the second cavity portion 4B. On the other hand, the lower end portion of the sintered pellet 2 is fitted in the first cavity portion 4A and is in tight contact with the inner wall while projecting to the lower side of the crucible 1.

The gap between the first cavity portion 4A and the sintered pellet 2 fitted in the first cavity portion 4A is preferably as small as possible to prevent the molten vapor deposition material from flowing into the gap. However, since the crucible 1 is normally made of a metal (e.g., copper) having a high thermal conductivity and cooled by the water-cooled copper hearth that is in contact with the crucible 1, the molten vapor deposition material does not flow into the gap so much and hardens without any problem.

When the upper surface portion of the vapor deposition material formed from the sintered pellet 2 is heated, molten, and evaporated upon being irradiated with the electron beam 11, the sintered pellet 2 gradually becomes small from the upper surface, and a recessed portion 13 deep at its center is formed. The heated and molten vapor deposition material flows into an annular gap 7 formed between the sintered pellet 2 and the inner wall of the crucible 1 that defines the second cavity portion 4B. When the vapor deposition material comes into contact with the inner wall of the second cavity portion 4B and the step surface 5A of the step like portion 5, the vapor deposition material cools, hardens, and sticks. Referring to Fig. 3, reference numeral 2A denotes a cooled and hardened portion of the molten sintered pellet at the end of vapor deposition; and 2B, an unmolten portion.

When the vapor deposition process is ended, the crucible 1 is removed from the vacuum apparatus. The residual sintered pellet is separated from the crucible 1 to reuse the crucible 1. As a detailed method, for example, the crucible 1 is inverted, the sintered pellet 2 is struck by an appropriate tool such as a hammer or a metal rod (push rod) to break the outer peripheral portion of the molten and hardened portion 2A, thereby separating the sintered pellet 2 from the crucible 1. In this case, when the outer peripheral portion of the molten and hardened portion 2A ranges from above to below the step like portion 5, as shown in Fig. 3, the applied impact concentrates to a portion 15 that is in contact with the edge or ridge 5a of the step like portion 5, and so-called stress concentration due to the applied force occurs. The stress concentration portion 15 is relatively thin because the recessed portion 13 on the upper surface of the sintered pellet 2 becomes deep toward the center. Since that portion is easiest to break in the molten and hardened portion 2A, the sintered pellet 2 can easily be separated as compared to the conventional crucible (Japanese Utility Model Laid-Open No. 3-18162). Even when the sintered pellet 2 mainly formed from a vapor deposition material such as niobium oxide which has a high thermal conductivity and a high bonding strength to the inner wall surface of the crucible 1 is used, the vapor deposition material can easily be separated, and the crucible 1 does not deform. In the example described here, the sintered pellet 2 is struck from the lower side of the crucible 1. Instead, even when the surface of the sintered pellet 2 is struck from the upper surface of the crucible 1, the sintered pellet can easily be separated because the edge or ridge 5a of the step like portion 5 concentrates stress to the portion 15 corresponding to the edge or ridge of the sintered pellet.

When the molten and hardened portion 2A is broken to separate the sintered pellet 2 from the crucible 1, part of the molten and hardened portion 2A remains as small pieces without being separated from the inner wall of the crucible 1. To remove the small pieces, for example, a push rod is inserted from above or below the crucible 1, and a force is applied by, e.g., striking the small pieces, thereby breaking or peeling the small pieces. When the sintered pellet 2 is separated, the remaining small pieces are broken near the step like portion 5 and divided into parts. Since the bonding area is small, they can easily be removed. A corner portion 5c serving as a bonding portion between the step surface 5A of the step like portion 5 and the inner wall surface of the second cavity portion 4B may be formed into a curved surface, as in the enlarged view of Fig. 2A corresponding to the step like portion shown in Fig. 2. This structure can easily bring a tool such as a push rod into contact with the corner portion. Hence, small pieces remaining at the corner portion can easily be removed.

According to the first embodiment, the first cavity portion 4A has almost the same sectional shape as that of the sintered pellet 2. Hence, when a tool is inserted either from the upper or lower side of the crucible 1, and a force in parallel to the inner wall is applied for the opening 8 side of the first cavity portion 4A, the crucible hardly deforms because the first cavity portion 4A has no inner wall in the direction of applying the force. In addition, since the contact area between the first cavity portion 4A and the. columnar sintered pellet 2 can be increased, the vapor deposition material hardly flows from the gap.

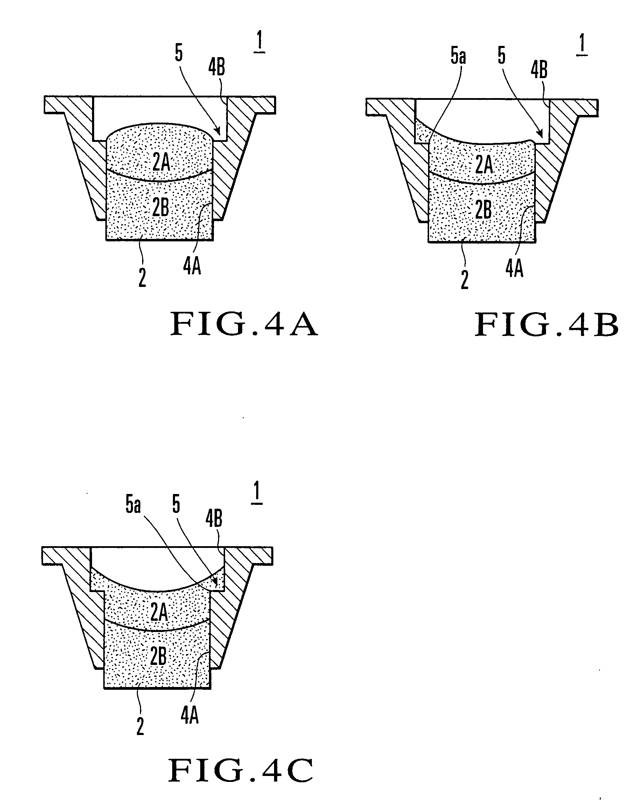

Figs. 4A to 4C show the states of the molten and hardened portion of the sintered pellet.

Fig. 4A shows a state wherein vapor deposition is ended before the molten and hardened portion 2A on the upper surface side reaches the wall surface of the second cavity portion 4B. In this case, since the molten and hardened portion is not in contact with the inner wall of the second cavity portion 4B, the bonding portion is only the inner wall of the first cavity portion 4A. Since the bonding area is small, the sintered pellet 2 can easily be separated from the crucible 1 only by breaking the molten and hardened portion 2A.

Fig. 4B shows a state wherein vapor deposition is ended when the molten and hardened portion 2A has partially reached the upper surface of the step like portion 5 and the wall surface of the second cavity portion 4B. In this case, since the molten and hardened portion is only partially in contact with the inner wall of the second cavity portion 4B, the bonding area is small. In addition, since a stress concentration portion is formed at the partially bonded portion due to the edge or ridge 5a of the step like portion 5, the molten and hardened portion 2A can easily be broken. Small pieces remaining on the inner wall surface are divided near the step like portion 5 into small bonding areas and can therefore easily be removed.

Fig. 4C shows a state wherein vapor deposition is ended when the molten and hardened portion 2A has reached almost the entire circumference of the upper surface of the step like portion 5 and the wall surface of the second cavity portion 4B. In this case, the bonding area between the crucible 1 and the molten and hardened portion of the sintered pellet is largest in these three examples. However, as in Fig. 4B, since a stress concentration portion is formed by the edge or ridge 5a of the step like portion 5, the molten and hardened portion 2A can easily be broken. In addition, small pieces remaining on the inner wall surface have small bonding areas due to the same reason as in Fig. 4B and can therefore easily be removed.

The bonding strength between the crucible inner wall and the vapor deposition material changes depending on the composition of the vapor deposition material, the material of the crucible, the heating condition, and the like. When a vapor deposition material such as niobium oxide having a high thermal conductivity is used, heat is readily transmitted to the peripheral portion around the portion where the electron beam hits. Since the melting amount near the inner wall of the crucible increases, the contact area between the vapor deposition material and the crucible also increases, and the bonding strength of the vapor deposition material to the crucible increases. Even in this case, the vapor deposition material can easily be removed by using the present invention.

The axial-direction (longitudinal direction) position of the step like portion of the present invention will be examined next.

Vapor deposition was executed under the same condition using crucibles having no step like portion. A number of crucibles 1 after vapor deposition were observed when vapor deposition was satisfactorily done. In many crucibles 1, the outer peripheral portion of the molten and hardened portion 2A stuck to an about 5- to 10-mm wide portion from the position lower then the upper surface of the crucible 1 by about 0 to 3 mm. At this time, the center of the upper surface of the sintered pellet 2 was at a position lower than the upper surface of the crucible 1 by about 8 to 10 mm. The step like portion 5 was arranged at a position lower than the upper surface of the crucible 1 by about 5 mm because it was more effective to form the step like portion 5 almost at the intermediate position of the molten and hardened portion 2A. This is because when the position deviates from the intermediate position, the sticking area on one of the upper and lower sides of the step like portion 5 increases to make it hard to remove the sintered pellet. The position of the step like portion 5 changes depending on the vaporization amount of the sintered pellet 2. As a condition, letting Y be the height of the crucible 1, and X be the thickness of the molten and hardened portion sticking to the inner wall at the end of vapor deposition, as shown in Fig. 3, the formation position of the step like portion 5 preferably ranges from a position P1 lower than the upper surface of the crucible 1 by X/2 to a position P2 higher than the lower surface by X/2. Outside this range, it is difficult to set the step like portion almost at the intermediate position of the molten and hardened portion. More specifically, to set the step like portion almost at the intermediate position above the position P1, the vapor deposition material may project from the upper side at a high probability. To set the step like portion almost at the intermediate position under the position P2, the molten vapor deposition material may flow from the lower side of the crucible 1 at a high probability. Note that since the value X largely varies, the average value or, for the sake of safety, the maximum value may be used. The outer peripheral portion of the molten and hardened portion 2A preferably ranges from above to below the step like portion 5, as shown in Fig. 3, at the end of vapor deposition. Since the value X changes depending on the vapor deposition material or vapor deposition condition, the height (formation position) of the step like portion 5 is preferably appropriately set in accordance with the vapor deposition material or condition.

The sintered pellet 2 used in this embodiment has a circular cross section. However, appropriate shapes such as a rectangular shape and elliptical shape are also included.

The first and second cavity portions need not always have similar sectional shapes.

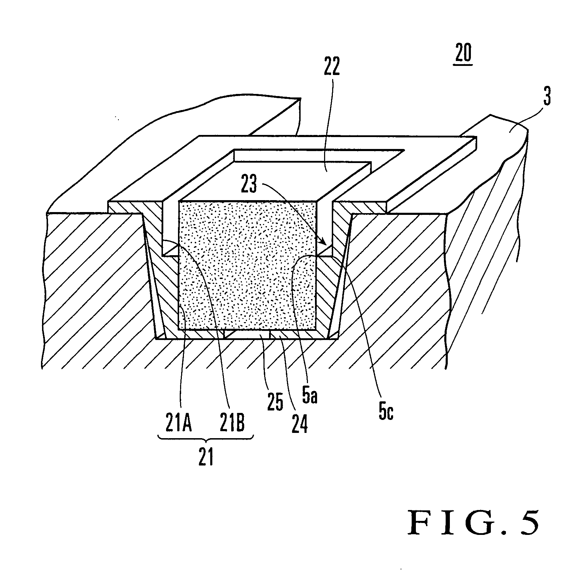

Fig. 5 shows the second embodiment of the present invention in which a sintered pellet has a prismatic shape, and the lower opening is partially open. In this embodiment, a sintered pellet 22 is formed into a prismatic shape, and a crucible 20 has a stepped cavity 21 having a rectangular cross section and capable of receiving the prismatic sintered pellet 22. The cavity 21 has a first cavity portion 21A having a rectangular cross section with almost the same shape as that of the sintered pellet 22, and a second cavity portion 21B having a rectangular cross section larger than the first cavity portion 21A. A step like portion 23 is formed at the boundary between the two cavity portions. Additionally, in this embodiment, the lower opening of the crucible 20 is partially open. For this purpose, the crucible 20 has a bottom plate 24. A hole 25 through which a push rod is inserted to push the sintered pellet 22 is formed at the center of the bottom plate 24. The remaining parts are the same as in the first embodiment.

Even in the structure shown in Fig. 5, the step like portion 23 is arranged, as in the first embodiment. Hence, it is obvious that the sintered pellet 22 after vapor deposition can easily be separated. In this case, however, if the sintered pellet 22 is struck from the upper side, the sintered pellet 22 is pressed against the bottom plate 24, and the crucible 20 may deform. To separate the sintered pellet 22 while preventing such deformation, the sintered pellet 22 must be struck with a tool from the lower hole 25.

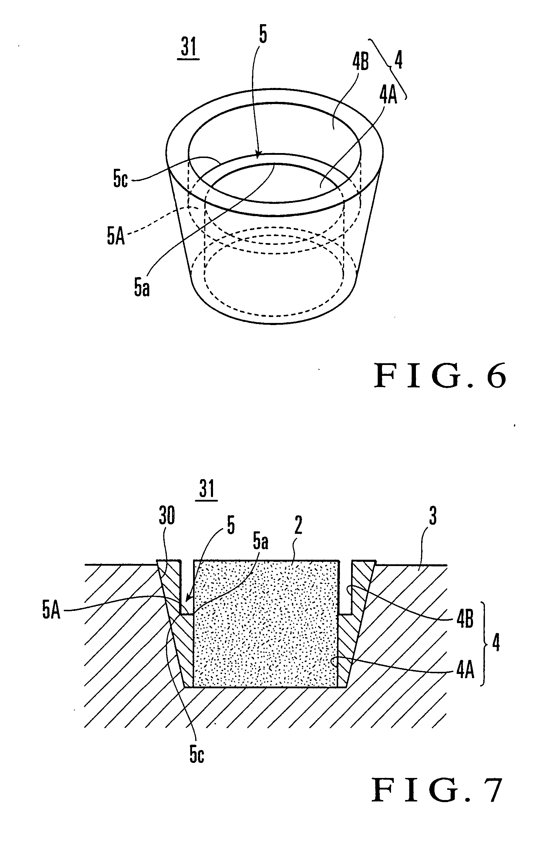

Figs. 6 and 7 show the third embodiment of the present invention in which a water-cooled copper hearth 3 has a circular tapered recessed portion 30, and the outer shape of a crucible 31 is formed into an inverted frustoconical shape such that the lower end side has a diameter smaller than that of the upper end side, and the crucible can fit in the tapered recessed portion 30. The remaining parts are almost the same as in the embodiment shown in Fig. 1, and the same reference numerals as in Fig. 1 denote the same parts in Figs. 6 and 7.

Even in this structure, since a step like portion 5 is formed, as in the above embodiments, a sintered pellet 2 after vapor deposition can easily be separated.

In the above-described embodiments, the edge or ridge (5a) of the step like portion 5 or 23 is almost right-angled. However, the present invention is not limited to this. For the step like portion 5 or 23, as the angle of the edge or ridge 5a decreases, stress generated by the edge or ridge 5a of the step like portion 5 or 23 more readily concentrates, and the molten and hardened portion sticking to the inner wall surface of the crucible 1 or 20 can more easily be broken. When the angle of the edge or ridge 5a of the step like portion 5 increases, the angle of the corner portion 5c made of the inner wall of the second cavity portion and the step surface 5A increases, and small pieces remaining at the corner portion 5c can more easily be removed. To obtain both the advantages, the angle of the edge or ridge of the step like portion is more preferably close to a right angle.

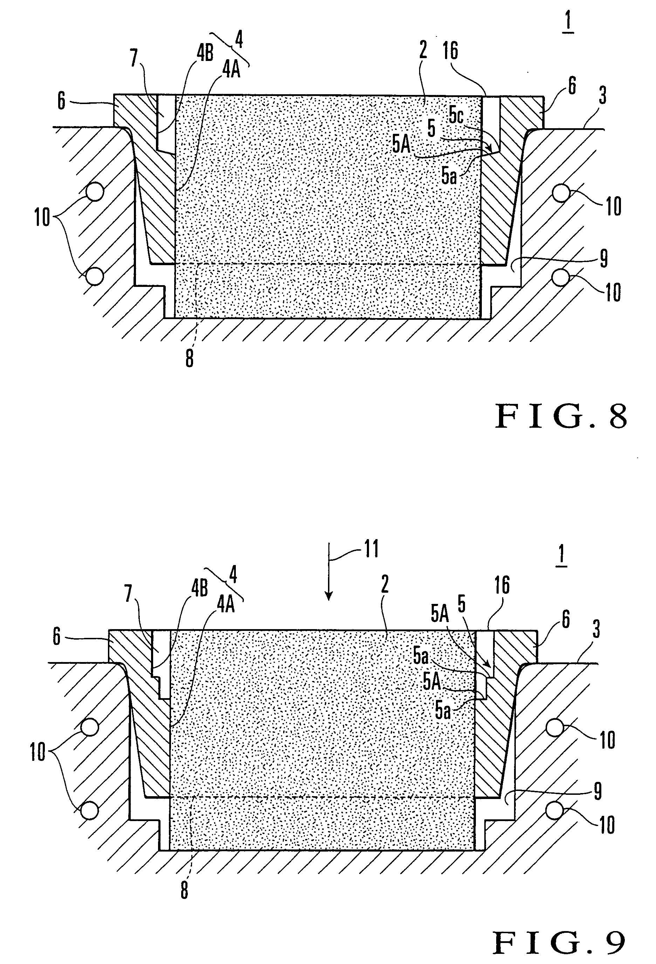

Fig. 8 shows the fourth embodiment of the present invention. The angle of an edge or ridge 5a of a step like portion 5 is larger than 90°. More specifically, a step surface 5A of the step like portion 5 is tapered toward the center of a crucible 1. Even in this structure, when an external force is applied to a molten and hardened sintered pellet, stress can concentrate to a portion corresponding to the edge or ridge 5a. Hence, the same effect as in the above-described embodiments can be obtained.

Fig. 9 shows the fifth embodiment of the present invention in which a plurality of step like portions are formed. Referring to Fig. 9, a crucible 1 has a cavity 4 formed as a through hole open to the upper and lower sides. The cavity 4 has a first cavity portion 4A having such a hole diameter that the lower end portion of a sintered pellet 2 can fit in, and a second cavity portion 4B located above the first cavity portion 4A and having a hole diameter larger than that of the first cavity portion 4A. A step like portion 5 having two steps is formed at the connection portion between the cavity portions. Hence, the step like portion 5 has two step surfaces 5A and two edges or ridges 5a. The number of steps of the step like portion 5 is not limited to two and may be three or more.

As shown in Fig. 9, when the step like portion 5 having two steps is formed, the height of the outer peripheral portion of the molten and hardened portion of the sintered pellet 2 at the end of vapor deposition preferably ranges from above to below at least one step of the step like portion 5. Accordingly, since a stress concentration portion is formed at the molten and hardened portion corresponding to a portion near the edge or ridge 5a of at least one step like portion, the sintered pellet after vapor deposition can easily be separated. When the molten and hardened portion sticks to the two steps of the step like portion 5, a stress concentration portion is formed at each edge or ridge 5a. Hence, small pieces remaining on the inner wall surface are easily divided near each step of the step like portion 5 and can easily be removed.

Even when the height position or height width of the molten and hardened portion has changed, the step like portion 5 can be located at the molten and hardened portion at a high probability by forming the step like portion 5 having the plurality of steps.

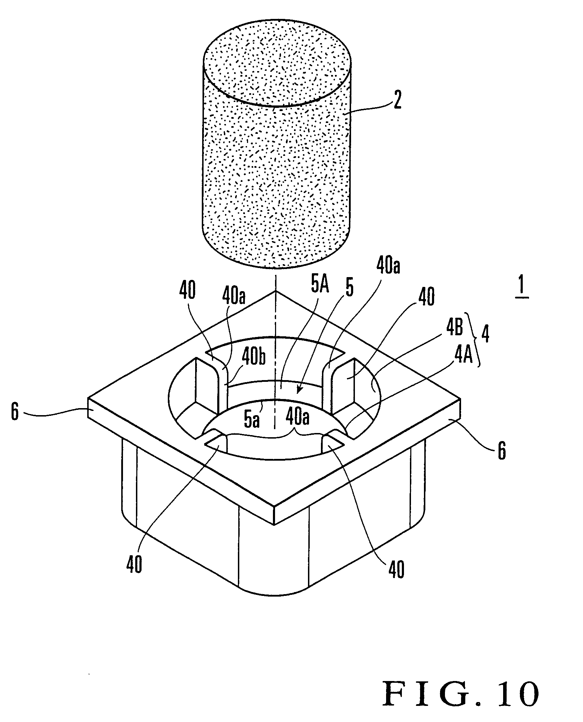

Fig. 10 shows the sixth embodiment of the present invention in which discontinuous step like portions are formed. In other words, step like portions are intermittently formed in the circumferential direction. Referring to Fig. 10, a crucible 1 has a cavity 4 formed as a through hole open to the upper and lower sides. The cavity 4 has a first cavity portion 4A having such a hole diameter that the lower end portion of a sintered pellet 2 can fit in, and a second cavity portion 4B located above the first cavity portion 4A and having a hole diameter larger than that of the first cavity portion 4A. A step like portion 5 is formed at the connection portion between the cavity portions. In addition, the second cavity portion 4B is circumferentially divided into four parts by four projecting portions 40. The projecting portions 40 are integrally formed at an equal interval in the circumferential direction on a step surface 5A of the step like portion 5 along the inner wall surface of the second cavity portion 4B. The size of each projecting portion 40 in the radial direction of the crucible is the same as the width (size in the radial direction of the crucible) of the step surface 5A not to impede insertion of the sintered pellet 2 into the first cavity portion 4A. Each upper inner edge 40a is chamfered into an arc to facilitate insertion of the sintered pellet 2. Hence, a surface 40b of the projecting portion 40, which is directed to the center in the radial direction of the cavity, forms the same surface as the inner wall surface of the first cavity portion 4A. The height of the projecting portion 40 reaches the upper surface of the crucible 1. However, the present invention is not limited to this, and an appropriate height can be set in accordance with conditions.

In the crucible 1 having the structure shown in Fig. 10, not only an edge or ridge 5a of the step like portion 5 but also the edge or ridge of each projecting portion 40 has a stress concentration portion against the sintered pellet 2. Hence, the pellet molten and hardened on the inner wall surface of the second cavity portion 4B can easily be separated in the circumferential direction of the inner wall surface. When the region where the step like portion 5 is present between the first cavity portion 4A and the second cavity portion 4B is larger than the region where the projecting portions 40 are present, the sintered pellet 2 after vapor deposition can easily be separated. Furthermore, when the projecting bodies are formed, the sintered pellet 2 can be inserted from the second cavity portion 4B side without being caught by the step like portion 5. Hence, the sintered pellet 2 can easily charged in the crucible 1.

As has been described above, according to the vapor deposition crucible of the present invention, the sintered pellet which is made of a vapor deposition material and molten and sticking to the inner wall surface of the crucible can easily be broken. Since the sintered pellet can easily be separated without deforming the crucible, the service life of the crucible can be prolonged. In addition, since the crucible needs to only have a step like portion, the structure is simple and easy to manufacture.

## Claims

1. A vapor deposition crucible **characterized by** comprising a crucible main body which is open to upper and lower sides and has a cavity (4) in which a sintered pellet as a vapor deposition material is stored,
wherein the cavity of said crucible main body has two cavity portions (4A, 4B; 21A, 21B),
a first cavity portion (4A) connected to an opening (8) open to the lower side is formed to make the sintered pellet to be stored fit in the first cavity portion,
a second cavity portion (4B) connected to an opening (16) open to the upper side is formed to form a gap between the second cavity portion and the sintered pellet to be stored, and
a step like portion (5, 23) is at least partially formed at a connection portion between the first cavity portion and the second cavity portion.

2. A crucible according to claim 1, wherein the first cavity portion has substantially the same sectional shape as that of the sintered pellet to be inserted.

3. A crucible according to claim 1, wherein the step like portion formed at the connection portion between the first and second cavity portions continues in a circumferential direction of the crucible.

4. A crucible according to claim 3, wherein the step like portion comprises a plurality of step like portions.

5. A crucible according to claim 3, wherein the step like portion is formed from two surfaces so as to form an edge or ridge (5a).

6. A crucible according to claim 1, wherein the step like portion formed at the connection portion between the first and second cavity portions is discontinuous in a circumferential direction of the crucible.

7. A crucible according to claim 1, further comprising a flange portion formed around the opening open to the upper side of said crucible main body.

8. A vapor deposition crucible **characterized by** comprising a crucible main body which is open to upper and lower sides and has a cavity (4) in which a sintered pellet as a vapor deposition material is stored,
wherein the cavity of said crucible main body has at least one cavity portion (4A, 4B; 21A, 21B), and
an opening (16) open to the upper side has flange portions (6) which oppose each other and have a rectangular shape when viewed from the upper side.
